(19) **Europäisches Patentamt**
**European Patent Office**
**Office européen des brevets**

(11) **EP 4 413 384 B1**

(12) **EUROPEAN PATENT SPECIFICATION**

(45) Date of publication and mention
of the grant of the patent:
**15.10.2025  Bulletin 2025/42**

(21) Application number: **22793101.1**

(22) Date of filing: **23.09.2022**

(51) International Patent Classification (IPC):
*G01R 31/12* $^{(2020.01)}$

(52) Cooperative Patent Classification (CPC):
**G01R 31/12**

(86) International application number:
**PCT/CZ2022/000039**

(87) International publication number:
**WO 2023/056995 (13.04.2023 Gazette 2023/15)**

(54) **A METHOD OF DETECTING A PARTIAL DISCHARGE SIGNAL**

VERFAHREN ZUR DETEKTION EINES TEILENTLADUNGSSIGNALS

PROCÉDÉ DE DÉTECTION D'UN SIGNAL DE DÉCHARGE PARTIELLE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **07.10.2021  CZ 20210468**

(43) Date of publication of application:
**14.08.2024  Bulletin 2024/33**

(73) Proprietor: **Modemtec s.r.o.**
**73961 Trinec (CZ)**

(72) Inventors:
• **LISKA, Jindrich**
**332 02 Starý Plzenec (CZ)**
• **JAKL, Jan**
**32300 Plzen, Bolevec (CZ)**
• **KÜNKEL, Sven**
**30100 Plzen, Jizní Predmestí (CZ)**

(74) Representative: **Skoda, Milan**
**Nahoranska 308**
**549 01 Nove Mesto nad Metuji (CZ)**

(56) References cited:
**FR-A1- 2 996 312     US-A1- 2016 003 883**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

## Technical Field

The invention relates to a method of detecting a partial discharge signal, specifically to a method of detecting a partial discharge signal from a signal measured by a measuring device.

## State of the Art

The good condition of the insulation of electrical circuits is a basic condition for their proper function. The condition of the insulation is threatened by various factors, such as chemical, electrical or production imperfections. The end state of the insulation is an electric field breakdown and this breakdown is always built up of partial discharges, no matter what impairment of the state of the insulation is created by whichever degradation mechanism, for example degradation of the insulation due to inhomogeneities in production of the insulation, the formation of so-called cavities.

As the electric field approaches, due to polarisation, a positive charge accumulates on one side of the cavity and a negative charge accumulates on the other side. The value of these small charges increases until the moment when the resulting electric potential crosses the insulation barrier and the charges equalise. At that moment, a small discharge is generated, and since the flow of the balancing current stops after the charges have equalised, these discharges are termed partial discharges

Thus, partial discharges in power networks are high-frequency discharges that last in the order of units to tens of nanoseconds and partially bridge the insulation between conductors and appear in the vicinity of the conductors. Partial discharges in transmission networks usually occur in the amplitude of alternating current. Partial discharges generate high-frequency electromagnetic pulses that travel relatively long distances spreading through the power system. Partial discharges are detected in a selected location of the electrical network, usually in nodes such as substations, with the aim being measuring and identifying the partial discharge, its amplitude and phase, and the occurrence of partial discharges from the point of view of other parameters and the frequency of their occurrence to be further analysed with the aim of diagnosing the quality of the line and possible malfunctions.

From patent document US9390067, a partial discharge detection method is known, which uses two sensors installed at the ends of the line. Measurements at both ends must be synchronous in order to perform subsequent localisation of the discharge. Since the signals measured on the lines are disturbed by noises that can completely mask the resulting partial discharges, the Wavelet transform method in combination with statistical processing is used to detect the discharges. Subsequently, the parameters of the discharge are calculated, which are its amplitude, the area of the signal envelope, the phase with respect to the reference voltage, and the position of the partial discharge along the line is determined. The significant disadvantage of this method is the need to use two sensors, which must also be synchronised. Another disadvantage is that the use of the Wavelet Transform described in the patent has been shown in testing to be less robust in regards to higher levels of noise in the signal.

Another method of detection and localisation of partial discharges is known from another patent document US6809523. Discharges are analysed here in the frequency and time domain. This document states that a partial discharge will excite a signal frequency band from 200 kHz to 200 MHz. Depending on which part of the frequency spectrum the dominant amplitude is located, it can be decided whether the discharge occurred closer or further away from the sensor. In the case that the maximum amplitude is at lower frequencies, the discharge occurred at a greater distance than if the maximum amplitude had been at higher frequencies of the spectrum. Subsequently, the phase of the discharge relative to the reference voltage is determined in the time domain and localisation of the discharge is performed.

From patent document US20170336459, a system for the detection and localisation of partial discharges is known, which uses the so-called Phase resolving spectra for the analysis of partial discharges. Also mentioned in this patent is the characteristic of discharges that discharges that occur closer to the sensor have maximum amplitudes at higher frequencies of the spectrum, and discharges that occur at a greater distance that have a maximum value of the spectrum at lower frequencies.

The detection of partial discharges from at least two sensors is known from another patent document US8126664. Measurements at both locations must again be supplemented by synchronisation, which is further used for the localisation of discharges. The diagnostic module of the system uses the characteristics of discharges in the time and time-frequency domain, while the use of the classical short-term Fourier transform, Wavelet transform or Wigner-Ville distribution is assumed. The disadvantage is again the necessity of using two sensors, which greatly complicates not only the construction of the entire measurement system, but also the measurement and evaluation itself.

From patent document US2016003883A1 is known the method for detecting an electric arc in a photovoltaic installation, which comprises the following steps:

- Measurement (E6) of voltage values at at least one site of the electrical circuit of the photovoltaic installation;

- Digitization (E8) of the measured voltage values so as to form a data sampling x;
- Computation (E10) of a first indicator of presence of an electric arc, on the basis of a statistical computation on the data sampling x, from among the variance, a value analogous to the variance, or the interquartile range of the data sampling;
- Computation (E10) of a second indicator of presence of an electric arc, on the basis of a statistical computation on the data sampling based on one or more estimations of the mean and/or of the median of the data sampling;
- Comparison (E12) of the first and second indicators of presence of an electric arc with respective thresholds so as to deduce therefrom the presence or absence of an electric arc within the photovoltaic installation.

From other patent document FR2996312 is known the method for detecting a wavefront of a signal received by a sensor, the method comprising:

- calculating the variance V of the energy of the absolute value of the signal received in successive time intervals of width equal to the inverse of the maximum amplitude frequency of the filtered signal,
- determining a maximum value Vmax, a minimum value Vmin and an average value Vmoy of said variance over all of said time intervals,
- calculating a detection threshold S on the basis of the equation: S = Wk X Vmax Vmoy, with W = Vmax / Vmin and k < 0,
- comparing the variance values V with the threshold S, and
- determining a time To of detection of the wavefront as soon as the value of the variance exceeds the threshold value for the first time.

The main disadvantage of known technology is that most methods require the use of multiple sensors for their implementation, which greatly complicates the measurement.

The aim of the invention is to construct a method of detecting a partial discharge signal from a measured signal, which will bring highly reliable and accurate results, while the equipment which will be required to be used for its operation will be simple and therefore cheap, which will allow its mass use.

## Principle of the Invention

The mentioned shortcomings are largely removed and the objectives of the invention are fulfilled by a method of detecting a partial discharge signal, in particular the method of detecting the partial discharge signal from a measured signal by the measuring device at least one point of the electric network, characterised by that firstly the variables in the detection device are initialised and the parameters $N_{var}$, lag_max, dead_max are loaded, then the measured broad-spectrum analog signal is loaded at least once, which is converted into a digital signal in the digitising means, which is further band-pass filtered so that components unrelated to the manifestation of partial discharge are removed from it, with their frequency being identified as a frequency region where the typical broadband transient excitation of amplitudes due to partial discharges does not occur, and the variance of the filtered signal is then calculated from the filtered signal, which contains at least one time constant of the filter such that

$$\hat{\mu}[k] = \lambda \cdot \hat{\mu}[k-1] + (1-\lambda) \cdot pd_{filt}[k],$$

$$\hat{\sigma}^2[k] = \lambda \cdot \hat{\sigma}^2[k-1] + (1-\lambda) \cdot \left(pd_{filt}[k] - \hat{\mu}[k]\right)^2,$$

where:

$\lambda$ is a forgetting factor ranging from 0 to 1, with a typical value of the factor typically ranging from 0.9 to 0.999, where if the variation of the filtered signal exceeds a specified threshold, then the presence of a partial discharge is detected at time k,

$\hat{\mu}[k]$ is an estimate of the mean value of the filtered signal at time k, where the unit is the unit of the filtered signal, i.e. most often the voltage being in volts,

$\hat{\mu}[k-1]$ is an estimate of the mean value of the filtered signal at time k-1, where the unit is the unit of the filtered signal, the voltage being most often in volts,

$pd_{filt}[k]$ is the value of the filtered signal at time k, where the unit is the unit of the filtered signal, the voltage being most often in volts,

$\hat{\sigma}^2[k]$ is an estimate of the variance of the filtered signal at time k, where the unit is the square of the unit of the filtered signal, most often the square of the volt, and

$\hat{\sigma}^2[k$ - 1] is an estimate of the variance of the signal at time k-1, where the unit is the square of the unit of the filtered signal, most commonly the square of the volt.

It is to advantage that the signal is first pre-processed with a suitably chosen filter, whereby only a certain frequency band is left depending on the character of the measured signal. Furthermore, it is to advantage that the information about the partial discharge remains in the filtered signal. The variance is calculated from the filtered signal, and the calculation parameter is the forgetting factor. Two variances are used, one to detect the partial discharge and the other to subsequently determine the origin of the partial discharge. It is advantageous to calculate the second variance from the unfiltered signal to accurately determine the origin of the discharge.

It is to advantage when variables are initialised such that:

$$\hat{\mu}[1] = 0,$$

$$\hat{\sigma}^2[1] = 0,$$

$$\hat{\mu}_2[1] = 0,$$

$$\hat{\sigma}_2^2[1] = 0,$$

$$\hat{\mu}_3[1] = 0,$$

$$\hat{\mu}_{krit}[1] = 0.$$

The main advantage of this initialisation is the universal setting of the initial values of the variables, without the need to know the current state.

Furthermore, it is advantageous if, in the case of the presence of a partial discharge, the origin of the partial discharge is further determined by first determining the value of the variance $\hat{\sigma}_2^2$ such that:

$$\hat{\mu}_2[k] = \lambda_2 \cdot \hat{\mu}_2[k-1] + (1-\lambda_2) \cdot pd[k],$$

$$\hat{\sigma}_2^2[k] = \lambda_2 \cdot \hat{\sigma}_2^2[k-1] + (1-\lambda_2) \cdot (pd[k] - \hat{\mu}_2[k])^2,$$

where:

$\hat{\mu}_2[k]$ is an estimate of the mean value of the signal at time k, where the unit is the unit of the measured signal, the voltage being most often in volts,
$\lambda_2$ is the forgetting factor,
$\hat{\sigma}_2^2[k]$ is an estimate of the variance (dispersion) of the measured signal at time k, where the unit is the square of the unit of the measured signal, i.e. most often the square of the volt,
$\hat{\mu}_2[k$ - 1] is an estimate of the mean value of the signal at time k-1, where the unit is the unit of the measured signal, the voltage being most often in volts,
$\hat{\sigma}_2^2[k-1]$ is an estimate of the variance of the measured signal at time k-1, where the unit is the square of the unit of the measured signal, i.e. most often the square of the volt, and
$pd[k]$ is the value of the measured signal at time k, where the unit is the unit of the measured signal, the voltage being most often in volts,

and further, the proportion of variance value $\hat{\sigma}_2^2$ at time k and at time k-Nvar is determined such that:

$$\Delta\hat{\sigma}_2^2[k] = \frac{\hat{\sigma}_2^2[k]}{\hat{\sigma}_2^2[k - Nvar]}$$

where Nvar is a selectable parameter that indicates the number of variance samples (delayed computation) by which the denominator of the above fraction is shifted from the numerator, thus it can take any integer value, with a typical value being 20, and the time of the maximum is stored in memory k_max at a horizon shorter than lag_max, which is typically set to 250, from the current time k, where the start of the burst id_beg is determined such that:

$$id\_beg = k\_max - Nvar,$$

while if no new maximum is determined in the following dead_max samples, the moment id_beg is considered the start of the discharge, while if a new maximum $\Delta\hat{\sigma}_2^2$ of the function is found in the following dead_max samples, then this new moment id_beg is considered the start of the discharge, with the information about the start being updated in the memory discharges id_beg.

It is also to advantage that for each detected partial discharge, the precise moment of the start of the discharge is determined as the moment of the maximum of the function calculated as the ratio of the variances of two consecutive sliding windows. The advantage is that by applying this procedure, the beginning of the detected partial discharge is the maximum of the above-mentioned proportion, i.e. the maximum of the function $\Delta\hat{\sigma}_2^2$.

It is also to advantage if the search for the start of the discharge is terminated after the dead_max of samples from the moment of discharge detection, which is typically set to 50. The advantage of this approach is that the search for the beginning of the partial discharge is limited to a finite number of dead_max samples.

Furthermore, it is to advantage if, in the case of the presence of a partial discharge, the end id_end of the partial discharge is further determined so that the moment at which the value of the criterion function falls below 1.1 times the value of the criterion function at the beginning of the partial discharge it is declared as the end of the partial discharge, such that:

$$\hat{\mu}_3[k] = \lambda_3 \cdot \hat{\mu}_3[k - 1] + (1 - \lambda_3) \cdot pd[k],$$

$$\hat{\mu}_{krit}[k] = \lambda_3 \cdot \hat{\mu}_{krit}[k - 1] + (1 - \lambda_3) \cdot |pd[k] - \hat{\mu}_3[k]|,$$

$$\hat{\mu}_{krit}[id\_end] < 1{,}1 \cdot \hat{\mu}_{krit}[id\_beg],$$

where:

$\hat{\mu}_3[k]$ is an estimate of the mean value of the signal at time k, where the unit is the unit of the measured signal, the voltage being most often in volts,
$\lambda_3$ is the forgetting factor,
$\hat{\mu}_3[k$ - 1] is an estimate of the mean value of the signal at time k, where the unit is the unit of the measured signal, the voltage being most often in volts,
pd[k] is the value of the measured signal at time k, where the unit is the unit of the measured signal, the voltage being most often in volts,
$\hat{\mu}_{krit}[k]$ is an estimate of the mean value of the absolute value of the measured signal without the DC component at time k, where the unit is the unit of the measured signal, the voltage being most often in volts, and
$\hat{\mu}_{krit}[k$ - 1] is an estimate of the mean value of the absolute value of the measured signal without the DC component at time k-1, where the unit is the unit of the measured signal, the voltage being most often in volts.

It is to advantage that the end of the partial discharge is calculated from the recursively calculated sum of the absolute value of the signal and its value at the beginning and end of the partial discharge is compared. Another advantage of this procedure is the speed and simplicity of implementing this procedure in the measuring and evaluation device.

It is also to advantage if, in the presence of a partial discharge, the total charge Q is further determined such that:

$$Q = a \cdot \frac{1}{f_s} \sum_{i=id\_beg}^{id\_end} |pd[i]|$$

where:

$Q$ is the total charge determined, where the unit is the Coulomb,

$a$ is the calibration coefficient of the conversion of signal area to charge, with the unit being $\frac{A \cdot s}{V}$),

$f_s$ is the sampling frequency, where the unit is Hz, and
$i$ is the sum calculation index from sample id_beg to sample id_end.

The advantage of determining the total charge $Q$ is the possibility to determine the size of the discharge and thus categorise the partial discharge according to its size.

It to advantage when, in the presence of a partial discharge, the phase in the basic harmonic sinusoid of the voltage in the electricity network is further determined such that:

$$\varphi = \left(id_{beg}/f_s - t_0\right)\frac{360}{T},$$

where:

$\varphi$ is the initial phase of the network voltage at the moment of partial discharge, where the unit is degree,
$t_0$ is the absolute start time of the current voltage period,
$id\_beg$ the beginning of the discharge is identified,
$f_s$ is the sampling frequency, where the unit is Hz, and
$T$ is the duration of the last full period in seconds,

with the duration $T$ of the last full period being used as the AC voltage period and $t_0$ being the start time of the current voltage period.

The main advantage of the partial discharge signal detection method, according to the invention, is that the proposed method allows detecting a greater number of discharges (or nearly all) than the compared methods, which is very significant from the point of view of determining the degradation of the insulation properties of the line. Thanks to this, it is possible to simply and cheaply determine the insulation status of the object being measured. This method of online detection of partial discharges in electrical networks is based on advanced signal processing, most often measured by a measuring transformer at at least one location of the electrical system. Determining the moments in time when the sliding variance estimate exceeds the selected threshold means the detection of partial discharges. Subsequently, the process of loading the new value of the measured signal, calculating the filtered value of the signal, recursively calculating two sliding variances with different time constants, recursively calculating the moving sum used in determining the end of the discharge and finally calculating the parameters of partial discharges in the case of its detection is repeated repeatedly. The selectability of filter coefficients enables especially switching between PP and DP filters, as well as suitable settings of the filter parameters. The detection method uses a set of predefined filters, from which the one that will suppress unwanted noise the most while preserving the manifestations of the partial discharges being sought is selected for the given installation. The method of detection of the partial discharge signal, according to the invention, is directly focused on the detection of non-stationarities in the measured signal, i.e. "burst" type changes, to which it is very sensitive. Compared to the commonly used DWT method, the resulting detection is not disturbed by falsely identified partial discharges.

## Overview of the Figures

The invention will be explained in more detail with the help of the drawing, in which fig. 1 shows the graphic course of the partial discharge time course according to the first example of the design, fig. 2 shows the amplitude spectrogram of the partial discharge signal according to the first example of the design, fig. 3 shows the time course of the signal variance including the marked detection threshold of partial discharges according to the first example of the design, fig. 4 shows the time evolution of the partial discharge signal together with marking the beginning (circle) and end (square) of the partial discharge according to the first example of the design, fig. 5 shows the PDPR (Partial Discharge Phase Resolved) diagram according to the first example of the design, fig. 6 shows graphically the time course of a partial discharge according to the second example of the design, fig. 7 shows the amplitude spectrogram of the partial discharge signal according to the second example of the design, fig. 8 shows the time course of the variance of the signal including the indicated threshold for the detection of partial discharges according to the second example of the design, fig.9 shows the time evolution of the partial discharge signal along with marking the beginning (circle) and end (square) of the partial discharge according to the second example of the design, and fig. 10 shows the PDPR diagram according to the second example of the design.

## **Examples of the Performance of the Invention**

Example 1

The method of detecting the partial discharge signal from the measured signal is performed by a measuring device arranged at one point of the electrical network.

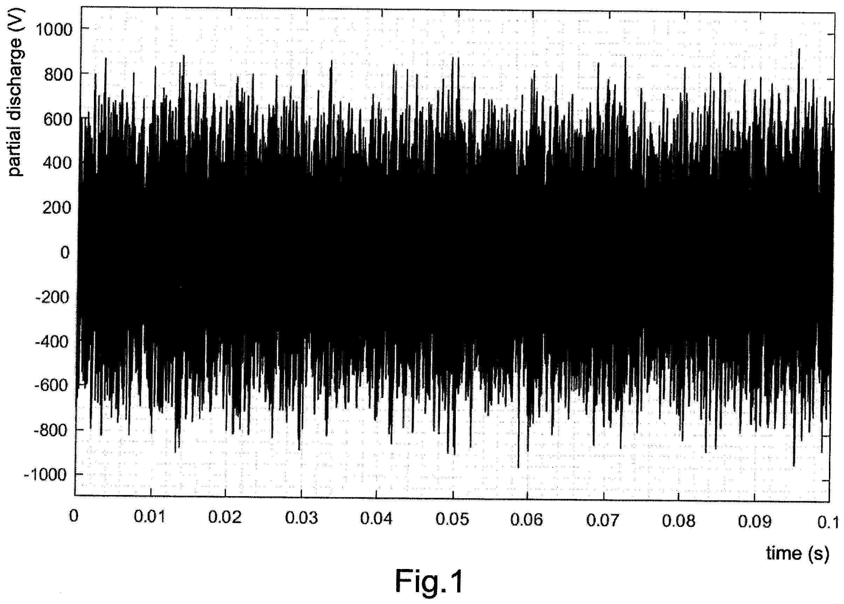

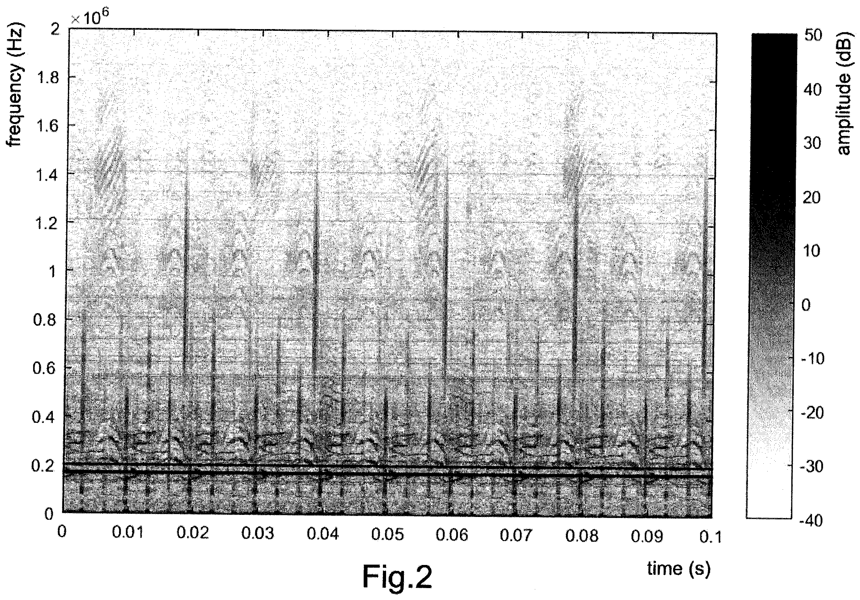

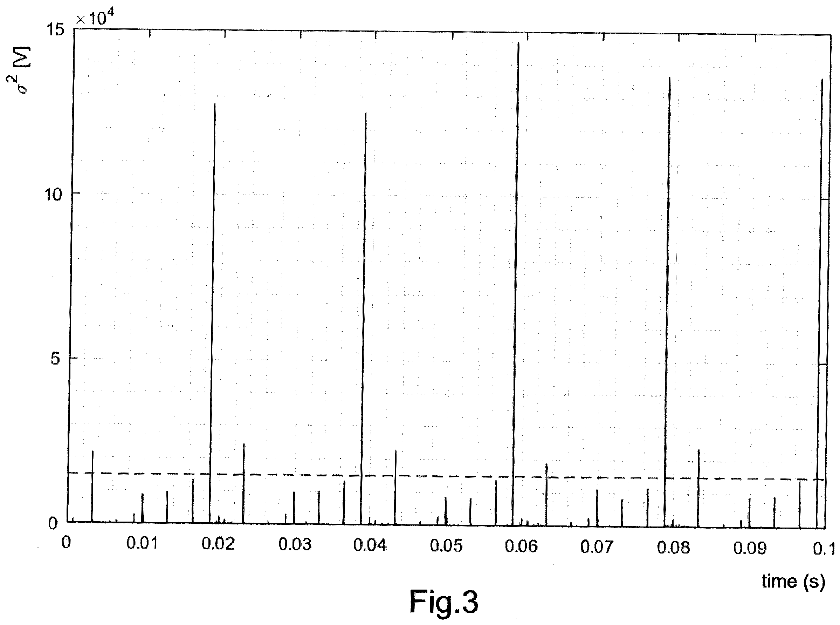

Firstly, variables are initialised in the detection device, which is a computer, and the parameters $N_{var} = 20$, lag_max = 250, dead_max = 50 are loaded, then the measured wide-spectrum analog signal is loaded at least once, which is converted into a digital signal in the digitising device (fig. 1), which is further band-pass filtered with a band-pass filter with a range from 400 kHz to 1.5 MHz so that components unrelated to the manifestation of partial discharge are removed from it, where their frequency is identified as a frequency range from 0 to 400 kHz and frequencies higher than 1.5 MHz, where there is no typical broadband transient excitation of amplitudes due to partial discharges (fig. 2), while the variance of the filtered signal is subsequently calculated from the filtered signal (fig. 3), which contains exactly one forgetting factor such that

$$\hat{\mu}[k] = \lambda \cdot \hat{\mu}[k-1] + (1-\lambda) \cdot pd_{filt}[k],$$

$$\hat{\sigma}^2[k] = \lambda \cdot \hat{\sigma}^2[k-1] + (1-\lambda) \cdot \left(pd_{filt}[k] - \hat{\mu}[k]\right)^2,$$

where:

$\lambda = 0.9667$ forgetting factor, while if the variance of the filtered signal exceeds the set threshold of 15000, the presence of a partial discharge is detected at time k,
$\hat{\mu}[k]$ is an estimate of the mean value of the filtered signal at time k (V),
$\hat{\mu}[k - 1]$ is an estimate of the mean value of the filtered signal at time k-1 (V),
$pd_{filt}[k]$ is the value of the filtered signal at time k (V),
$\hat{\sigma}^2[k]$ is an estimate of the variance (dispersion) of the filtered signal at time k in volts squared ($V^2$), and
$\hat{\sigma}^2[k - 1]$ is an estimate of the variance (dispersion) of the signal at time k-1 in volts squared ($V^2$).

Next, the variables are initialised so that:

$$\hat{\mu}[1] = 0,$$

$$\hat{\sigma}^2[1] = 0,$$

$$\hat{\mu}_2[1] = 0,$$

$$\hat{\sigma}_2^2[1] = 0,$$

$$\hat{\mu}_3[1] = 0,$$

$$\hat{\mu}_{krit}[1] = 0.$$

Furthermore, in the case of the presence of a partial discharge, the beginning of the partial discharge is determined by first determining the value of the variance $\hat{\sigma}_2^2$ such that:

$$\hat{\mu}_2[k] = \lambda_2 \cdot \hat{\mu}_2[k-1] + (1 - \lambda_2) \cdot pd[k],$$

$$\hat{\sigma}_2^2[k] = \lambda_2 \cdot \hat{\sigma}_2^2[k-1] + (1 - \lambda_2) \cdot (pd[k] - \hat{\mu}_2[k])^2,$$

where:

$\hat{\mu}_2[k]$ is an estimate of the mean value of the signal at time k (V),

$\lambda_2 = 0{,}9167$ is the forgetting factor,

$\hat{\sigma}_2^2[k]$ is an estimation of the variance (dispersion) of the measured signal at time k in the square of the volt (V$^2$),

$\hat{\mu}_2[k - 1]$ is an estimate of the mean value of the signal at time k-1 (V),

$\hat{\sigma}_2^2[k-1]$ is an estimation of the variance (dispersion) of the measured signal at time k-1 in volts squared (V$^2$), and

$pd[k]$ is the value of the measured signal at time k (V),

and further, the proportion of the variance value of $\hat{\sigma}_2^2$ at time k and at time k-Nvar is determined such that:

$$\Delta\hat{\sigma}_2^2[k] = \frac{\hat{\sigma}_2^2[k]}{\hat{\sigma}_2^2[k - Nvar]}$$

where Nvar = 20 is a parameter that indicates the number of variance samples (calculation delay) by which the denominator of the above-mentioned fraction is shifted compared to the numerator, and the maximum time k_max is stored in the memory in a horizon shorter than lag_max = 250 (number of time samples of the signal) from the current time k, with the start of the discharge id_beg determined such that:

$$id\_beg = k\_max - Nvar,$$

whereas if no new maximum is determined in the following dead_max=50 samples, the moment id_beg is considered to be the start of the discharge, while if a new maximum of the function is found in the following dead_max samples $\Delta\hat{\sigma}_2^2$ then this new moment id_beg is considered to be the start of the discharge, with the start of discharge id_beg being updated in memory.

After the expiration of dead_max=50 (number of signal time samples) samples from the moment of discharge detection, the search for the beginning of the discharge is finished.

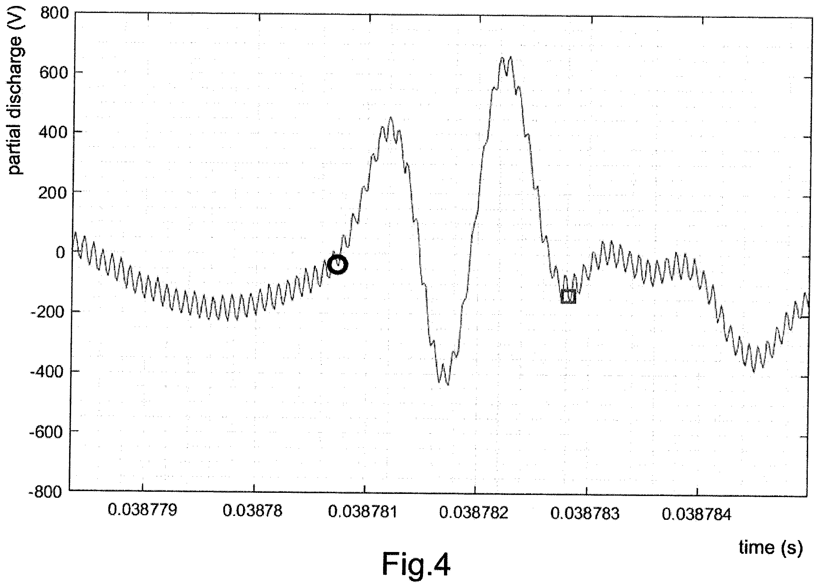

In the case of the presence of a partial discharge, the end id_end of the partial discharge is further determined so that the moment (fig. 4) at which the value of the criterion function falls below 1.1 times the value of the criterion function at the beginning of the partial discharge it is declared to be the end of the partial discharge, such that:

$$\hat{\mu}_3[k] = \lambda_3 \cdot \hat{\mu}_3[k-1] + (1 - \lambda_3) \cdot pd[k],$$

$$\hat{\mu}_{krit}[k] = \lambda_3 \cdot \hat{\mu}_{krit}[k-1] + (1 - \lambda_3) \cdot |pd[k] - \hat{\mu}_3[k]|,$$

$$\hat{\mu}_{krit}[id\_end] < 1{,}1 \cdot \hat{\mu}_{krit}[id\_beg],$$

where:

$\hat{\mu}_3[k]$ is an estimate of the mean value of the signal at time k (V),

$\lambda_3 = 0{,}9444$ is the forgetting factor,

$\hat{\mu}_3[k - 1]$ is an estimate of the mean value of the signal at time k-1 (V),

$pd[k]$ is the value of the measured signal at time k (V),

$\hat{\mu}_{krit}[k]$ is an estimate of the mean value of the absolute value of the measured signal without the DC component at time k (V), and

$\hat{\mu}_{krit}[k - 1]$ is an estimate of the mean value of the absolute value of the measured signal without the DC component at time k-1 (V).

In the presence of a partial discharge, the total charge $Q$ is further determined such that:

$$Q = a \cdot \frac{1}{f_s} \sum_{i=id\_beg}^{id\_end} |pd[i]|$$

where:

$Q$ is the total determined charge (C),

$a$ = 4900is the calibration coefficient of conversion of signal area to charge, which has a unit $\frac{A \cdot s}{V}$,

$f_s$ = is the 60 MHz sampling frequency, and
i is the sum calculation index from sample id_beg to sample id_end.

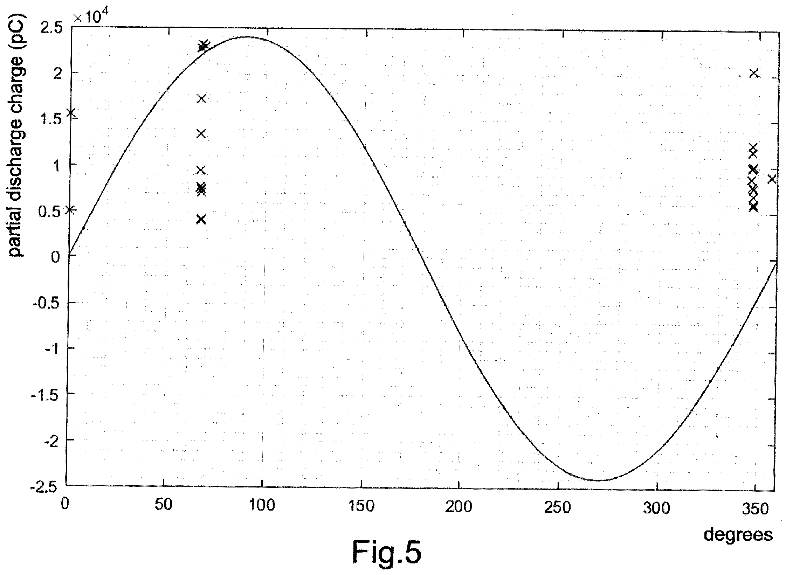

In the case of the presence of a partial discharge, the phase in the basic harmonic sinusoid of the voltage in the electricity network (fig. 5) is further determined such that:

$$\varphi = \left(id_{beg}/f_s - t_0\right)\frac{360}{T},$$

where:

$\varphi$ is the initial phase of the network voltage at the moment of partial discharge (°),
$t_0$ is the absolute start time of the current voltage period (s),
*id_beg* is the start of the discharge identified,
$f_s$ is the sampling frequency (Hz), and
$T$ is the duration of the last full period (s),
where the duration of the last full period T is used as the AC voltage period and $t_0$ is the start time of the current voltage period.

Example 2

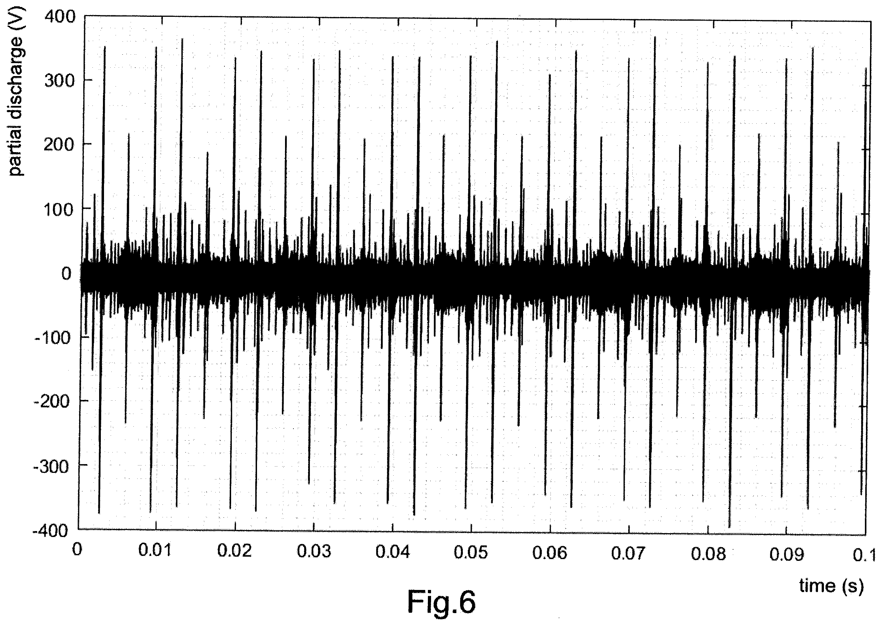

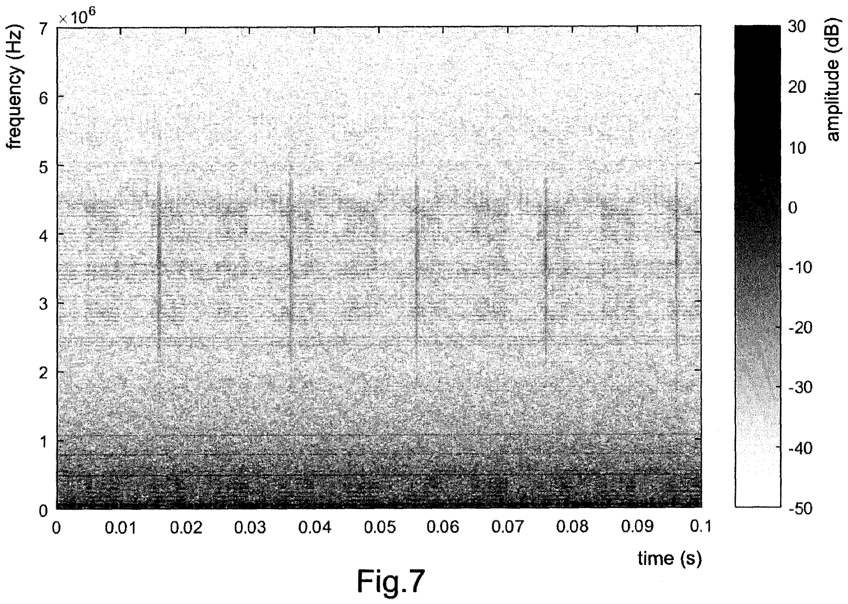

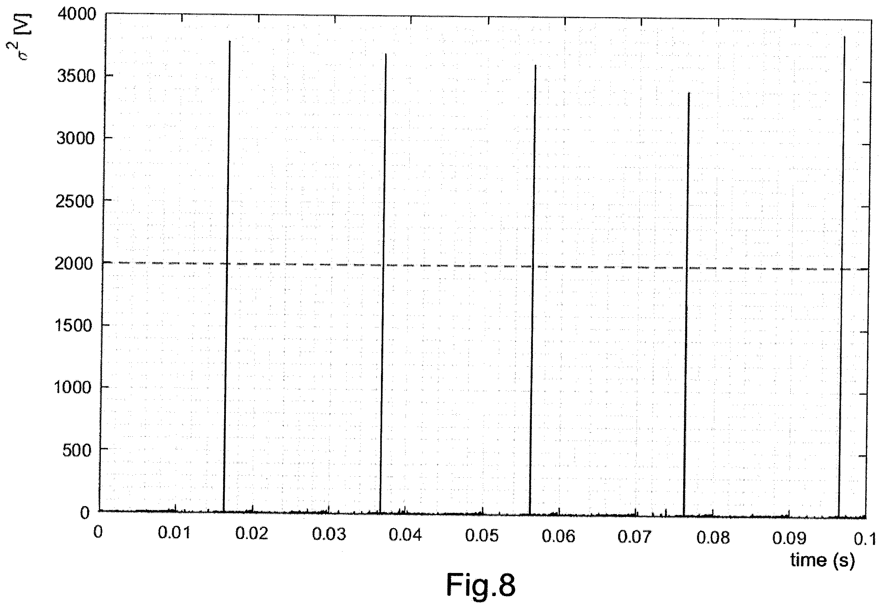

The method of detecting the partial discharge signal from the measured signal is performed by a measuring device arranged at one point of the electrical network.
Firstly, variables are initialised in the detection device, which is a special device for detection, and the parameters $N_{var}$ = 20, lag_max = 250, dead_max = 50 are loaded, then the measured wide-spectrum analog signal is loaded at least once, which is converted into a digital signal in the digitiser (fig. 6), which is further band-pass filtered with a band-pass filter with a range from 2 MHz to 5 MHz, so that the components that are not related to the manifestation of a partial discharge are removed from it, where their frequency is identified as a frequency range from 0 to 2 MHz and a frequency higher than 5 MHz, where there is no typical broadband transient excitation of amplitudes due to partial discharges (fig. 7), with the variance of the filtered signal being subsequently calculated from the filtered signal (fig. 8), which contains at least one time constant of the filter such that

$$\hat{\mu}[k] = \lambda \cdot \hat{\mu}[k - 1] + (1 - \lambda) \cdot pd_{filt}[k],$$

$$\hat{\sigma}^2[k] = \lambda \cdot \hat{\sigma}^2[k - 1] + (1 - \lambda) \cdot \left(pd_{filt}[k] - \hat{\mu}[k]\right)^2,$$

where:

$\lambda$ = 0.9667 is the forgetting factor, while if the variance of the filtered signal exceeds the set threshold of 2000, the presence of a partial discharge is detected at time k,
$\hat{\mu}[k]$ is an estimate of the mean value of the filtered signal at time k (V),
$\hat{\mu}[k - 1]$ is an estimate of the mean value of the filtered signal at time k-1 (V),

$pd_{filt}[k]$ is the value of the filtered signal at time k (V),
$\hat{\sigma}^2[k]$ is an estimate of the variance (dispersion) of the filtered signal at time k in volts squared (V$^2$), and
$\hat{\sigma}^2[k-1]$ is an estimate of the variance (dispersion) of the signal at time k-1 in volts squared (V$^2$).

Next, the variables are initialised such that:

$$\hat{\mu}[1] = 0,$$

$$\hat{\sigma}^2[1] = 0,$$

$$\hat{\mu}_2[1] = 0,$$

$$\hat{\sigma}_2^2[1] = 0,$$

$$\hat{\mu}_3[1] = 0,$$

$$\hat{\mu}_{krit}[1] = 0.$$

In the case of the presence of a partial discharge, the beginning of the partial discharge is determined by first determining the value of the variance $\hat{\sigma}_2^2$ such that:

$$\hat{\mu}_2[k] = \lambda_2 \cdot \hat{\mu}_2[k-1] + (1 - \lambda_2) \cdot pd[k],$$

$$\hat{\sigma}_2^2[k] = \lambda_2 \cdot \hat{\sigma}_2^2[k-1] + (1 - \lambda_2) \cdot (pd[k] - \hat{\mu}_2[k])^2,$$

where:

$\hat{\mu}_2[k]$ is an estimate of the mean value of the signal at time k (V),
$\lambda_2 = 0{,}9167$ is the forgetting factor,
$\hat{\sigma}_2^2[k]$ is an estimate of the variance (dispersion) of the filtered signal at time k in volts squared (V$^2$), and
$\hat{\mu}_2[k-1]$ is an estimate of the mean value of the signal at time k-1 (V),
$\hat{\sigma}_2^2[k-1]$ is an estimate of the variance (dispersion) of the filtered signal at time k in volts squared (V$^2$), and
$pd[k]$ is the value of the measured signal at time k in volts,

and further, the proportion of the variance value of $\hat{\sigma}_2^2$ at time k and at time k-Nvar is determined such that:

$$\Delta\hat{\sigma}_2^2[k] = \frac{\hat{\sigma}_2^2[k]}{\hat{\sigma}_2^2[k - Nvar]}$$

where Nvar = 20 is a parameter that indicates the number of variance samples (delayed calculation) by which the denominator of the above fraction is shifted compared to the numerator, and the maximum time k_max being further stored in the memory in a horizon shorter than lag_max=250 (the number of signal time samples) from the current time k, with the start of the discharge id_beg determined such that:

$$id\_beg = k\_max - Nvar,$$

whereas if no new maximum is determined in the following dead_max=50 samples, the moment id_beg is considered the start of the discharge, while if a new maximum of the function $\Delta\hat{\sigma}_2^2$ is found in the following dead_max samples, then this new moment id_beg is considered to be the start of the discharge, with the data being updated in the memory about the beginning of the discharge id_beg.

After the expiration of dead_max=50 (number of signal time samples) samples from the moment of discharge detection, the search for the beginning of the discharge is completed.

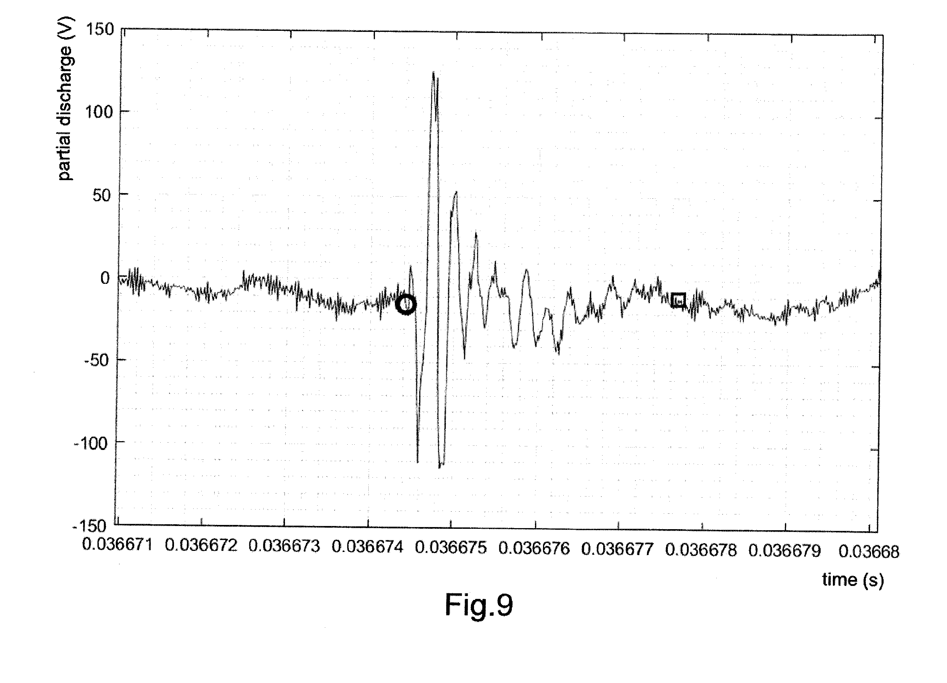

In the case of the presence of a partial discharge, the end id_end of the partial discharge is further determined so that the moment (fig. 9) at which the value of the criterion function falls below 1.1 times the value of the criterion function at the beginning of the partial discharge is declared to be the end of the partial discharge, such that:

$$\hat{\mu}_3[k] = \lambda_3 \cdot \hat{\mu}_3[k-1] + (1-\lambda_3) \cdot pd[k],$$

$$\hat{\mu}_{krit}[k] = \lambda_3 \cdot \hat{\mu}_{krit}[k-1] + (1-\lambda_3) \cdot |pd[k] - \hat{\mu}_3[k]|,$$

$$\hat{\mu}_{krit}[id\_end] < 1,1 \cdot \hat{\mu}_{krit}[id\_beg],$$

where:

$\hat{\mu}_3[k]$ is an estimate of the mean value of the signal at time k (V),
$\lambda_3$ = 0,9444 is the forgetting factor,
$\hat{\mu}_3[k - 1]$ is an estimate of the mean value of the signal at time k-1 (V),
$pd[k]$ is the value of the measured signal at time k (V),
$\hat{\mu}_{krit}[k]$ is an estimate of the mean value of the absolute value of the measured signal without the DC component at time k (V),
$\hat{\mu}_{krit}[k - 1]$ is an estimate of the mean value of the absolute value of the measured signal without the DC component at time k-1 (V).

In the case of the presence of a partial discharge, the total charge $Q$ is further determined such that:

$$Q = a \cdot \frac{1}{f_s} \sum_{i=id\_beg}^{id\_end} |pd[i]|$$

where:

$Q$ is the total determined charge (C),

$a$ = 4500is the calibration coefficient of conversion of signal area to charge, which has a unit $\frac{A \cdot s}{V}$,

$f_s$ = 60$MHz$ is the sampling frequency, and
i is the sum calculation index from sample id_beg to sample id_end.

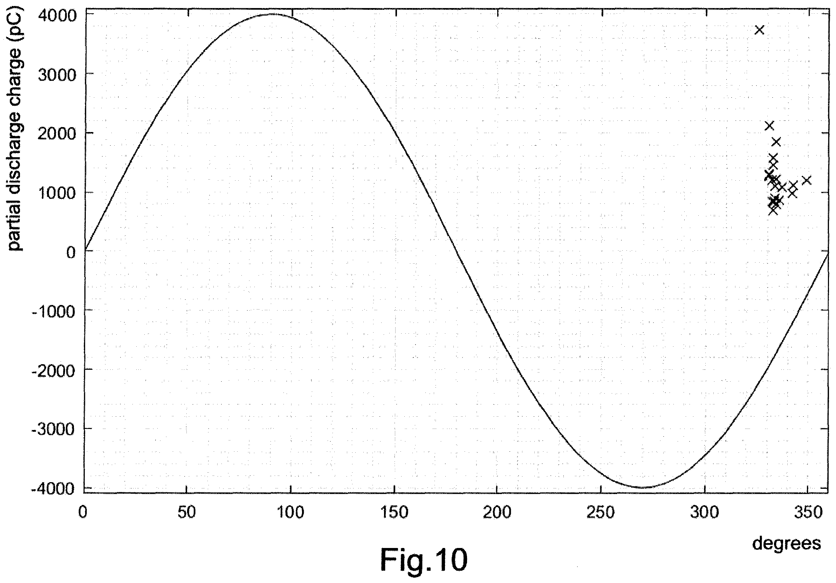

In the case of the presence of a partial discharge, the phase in the basic harmonic sinusoid of the voltage in the electricity network (fig. 10) is further determined such that:

$$\varphi = (id_{beg}/f_s - t_0)\frac{360}{T},$$

where:

$\varphi$ is the initial phase of the voltage in the network at the moment of the occurrence of partial discharge (°),
$t_0$ is the absolute start time of the current voltage period (s),
*id_beg* is the start of the discharge identified,
$f_s$ is the sampling frequency (Hz), and
$T$ is the duration of the last full period (s),
with the duration of the last full period $T$ being used as the AC voltage period and $t_0$ being the start time of the current voltage period.

**Industrial Application**

The method of detecting a partial discharge signal, can specifically be used to detect the partial discharge signal in common industrial applications, especially on power lines.

**Claims**

1. A method of detecting a partial discharge signal, in particular a method of detecting a partial discharge signal from a signal measured by a measuring device at at least one point of the electrical network, according to which the variables in the detection device are first initialised and then the parameters $N_{var}$, lag_max, dead_max are loaded, then the measured broad-spectrum analog signal is loaded at least once, which is converted into a digital signal in the digitising means, **characterised by that** the digital signal is further band-pass filtered so that components unrelated to the manifestation of partial discharge are removed from it, where their frequency is identified as a frequency region where the typical broadband transient excitation of amplitudes due to partial discharges does not occur, and the variance of the filtered signal is then calculated from the filtered signal, which contains at least one time constant of the filter such that,

$$\hat{\mu}[k] = \lambda \cdot \hat{\mu}[k-1] + (1-\lambda) \cdot pd_{filt}[k],$$

$$\hat{\sigma}^2[k] = \lambda \cdot \hat{\sigma}^2[k-1] + (1-\lambda) \cdot \left( pd_{filt}[k] - \hat{\mu}[k] \right)^2,$$

where:

$\lambda$ is the forgetting factor in the range 0 to 1, whereby if the variance of the filtered signal exceeds a specified threshold, the presence of a partial discharge is detected at time k,
$\hat{\mu}[k]$ is an estimate of the mean value of the filtered signal at time k (V),
$\hat{\mu}[k-1]$ is an estimate of the mean value of the filtered signal at time k-1,
$pd_{filt}[k]$ is the value of the filtered signal at time k,
$\hat{\sigma}^2[k]$ is an estimate of the variance of the filtered signal at time k, and
$\hat{\sigma}^2[k-1]$ is an estimate of the variance of the signal at time k-1.

2. The method of detecting a partial discharge signal, according to claim 1, **characterised by that** the variables are initialised such that:

$$\hat{\mu}[1] = 0,$$

$$\hat{\sigma}^2[1] = 0,$$

$$\hat{\mu}_2[1] = 0,$$

$$\hat{\sigma}_2^2[1] = 0,$$

$$\hat{\mu}_3[1] = 0,$$

$$\hat{\mu}_{krit}[1] = 0.$$

3. The method of detecting a partial discharge signal, according to either one of claims 1 and 2, **characterised by that** that in the case of the presence of a partial discharge, the beginning of the partial discharge is further determined by first determining the value of the variance $\hat{\sigma}_2^2$ so that:

$$\hat{\mu}_2[k] = \lambda_2 \cdot \hat{\mu}_2[k-1] + (1-\lambda_2) \cdot pd[k],$$

$$\hat{\sigma}_2^2[k] = \lambda_2 \cdot \hat{\sigma}_2^2[k-1] + (1-\lambda_2) \cdot (pd[k] - \hat{\mu}_2[k])^2,$$

where:

$\hat{\mu}_2[k]$ is an estimate of the mean value of the signal at time k,
$\lambda_2$ is the forgetting factor,
$\hat{\sigma}_2^2[k]$ is an estimate of the variance (dispersion) of the measured signal at time k,
$\hat{\mu}_2[k - 1]$ is an estimate of the mean value of the signal at time k-1,
$\hat{\sigma}_2^2[k-1]$ is an estimate of the variance of the measured signal at time k-1, and
$pd[k]$ is the value of the measured signal at time k,

and further, the proportion of the variance value of $\hat{\sigma}_2^2$ at time k and at time k-Nvar is determined such that:

$$\Delta\hat{\sigma}_2^2[k] = \frac{\hat{\sigma}_2^2[k]}{\hat{\sigma}_2^2[k-Nvar]}$$

where Nvar is an selectable parameter that indicates the number of variance samples by which the denominator of the above fraction is shifted from the numerator, and the time of the maximum k_max is stored in memory in a horizon shorter than lag_max from the current time k, and the start of the discharge id_beg is determined such that:

$$\text{id\_beg} = \text{k\_max} - \text{Nvar},$$

whereas if no new maximum is determined in the following dead_max samples, the moment id_beg is considered the start of the discharge, and if a new maximum of the function $\Delta\hat{\sigma}_2^2$ is found in the following dead_max samples, then this new moment id_beg is considered to be the start of the discharge, and the information about start of discharge id_beg is updated in the memory.

4. The method of detecting a partial discharge signal, according to claim 2, **characterised by that** after the **dead_max** of samples have elapsed from the moment of discharge detection, the search for the start of the discharge is terminated.

5. The method of detecting a partial discharge signal, according to any one of claims 1 to 3, **characterised by that** in the case of the presence of a partial discharge, the end id_end of the partial discharge is further determined so that the moment at which the value of the criterion function falls below 1.1 times the value of the criterion function at the beginning of the partial discharge it is declared as the end of the partial discharge, such that:

$$\hat{\mu}_3[k] = \lambda_3 \cdot \hat{\mu}_3[k-1] + (1-\lambda_3) \cdot pd[k],$$

$$\hat{\mu}_{krit}[k] = \lambda_3 \cdot \hat{\mu}_{krit}[k-1] + (1-\lambda_3) \cdot |pd[k] - \hat{\mu}_3[k]|,$$

$$\hat{\mu}_{krit}[id\_end] < 1{,}1 \cdot \hat{\mu}_{krit}[id\_beg],$$

where:

$\hat{\mu}_3[k]$ is an estimate of the mean value of the signal at time k,
$\lambda_3$ is the forgetting factor,
$\hat{\mu}_3[k - 1]$ is an estimate of the mean value of the signal at time k-1,
$pd[k]$ is the value of the measured signal at time k,
$\hat{\mu}_{krit}[k]$ is an estimate of the mean value of the absolute value of the measured signal without the DC component at

time k, and

$\hat{\mu}_{krit}[k-1]$ is an estimate of the mean absolute value of the measured signal without the DC component at time k-1.

6. The method of detecting a partial discharge signal, according to any one of claims 1 to 4, **characterised by that** in the case of the presence of a partial discharge, the total charge $Q$ is further determined such that:

$$Q = a \cdot \frac{1}{f_s} \sum_{i=id\_beg}^{id\_end} |pd[i]|$$

where:

$Q$ is the total determined charge,
$a$ is the calibration coefficient of the conversion of signal area to charge,
$f_s$ is the sampling frequency, and
$i$ is the sum calculation index from sample id_beg to sample id_end.

7. The method of detecting a partial discharge signal, according to any one of claims 1 to 5, **characterised by that** in the case of the presence of a partial discharge, the phase in the basic harmonic sinusoid of the voltage in the electrical network is further determined such that:

$$\varphi = \left(id_{beg}/f_s - t_0\right)\frac{360}{T},$$

where:

$\varphi$ is the initial phase of the voltage in the network at the moment of partial discharge,
$t_0$ is the absolute start time of the current voltage period,
$id\_beg$ is the start of the discharge identified,
$f_s$ is the sampling frequency (Hz), and
$T$ is the duration of the last full period (s),

where the duration of the last full period $T$ is used as the AC voltage period and $t_0$ is the start time of the current voltage period.

**Patentansprüche**

1. Methode zur Erfassung eines Teilentladungssignals, insbesondere die Methode zur Erfassung eines Teilentladungssignals aus einem von einer Messvorrichtung an mindestens einem Punkt des elektrischen Netzes gemessenen Signal, nach dem zunächst die Initialisierung der Variablen in der Detektionsvorrichtung und das Laden der Parameter $N_{var}$, lag_max, dead_max durchgeführt werden, anschließend wird das gemessene breitbandige Analogsignal mindestens einmal geladen, das in der Digitalisierungsvorrichtung in ein digitales Signal umgewandelt wird, **dadurch gekennzeichnet, dass** das digitale Signal weiter bandgefiltert wird, so dass davon die Komponente entfernt werden, die mit der Kundgebung der Teilentladung nicht zusammenhängen, wobei deren Frequenz als Frequenzbereich identifiziert wird, in dem die typische breitbandige vorübergehende Erregung von Amplituden durch den Einfluss von Teilentladungen nicht auftritt, wobei anschließend die Varianz des gefilterten Signals aus dem gefilterten Signal errechnet wird, die mindestens eine Zeitkonstante des Filters enthält, so dass

$$\hat{\mu}[k] = \lambda \cdot \hat{\mu}[k-1] + (1-\lambda) \cdot pd_{filt}[k],$$

$$\hat{\sigma}^2[k] = \lambda \cdot \hat{\sigma}^2[k-1] + (1-\lambda) \cdot \left(pd_{filt}[k] - \hat{\mu}[k]\right)^2,$$

wobei:

λ ist der Vergesslichkeitsfaktor im Bereich von 0 bis 1, wobei, wenn die Varianz des gefilterten Signals einen vorgegebenen Schwellenwert überschreitet, wird zum Zeitpunkt das Vorhandensein einer Teilentladung detektiert,

$\hat{\mu}[k]$ ist eine Schätzung des Mittelwertes des gefilterten Signals zum Zeitpunkt k,

$\hat{\mu}[k - 1]$ ist eine Schätzung des Mittelwertes des gefilterten Signals zum Zeitpunkt k-1,

$pd_{filt}[k]$ ist der Wert des gefilterten Signals zum Zeitpunkt k,

$\hat{\sigma}^2[k]$ ist eine Schätzung der Varianz des gefilterten Signals zum Zeitpunkt k, und

$\hat{\sigma}^2[k - 1]$ ist eine Schätzung der Varianz des Signals zum Zeitpunkt k-1.

2. Methode zur Erfassung eines Teilentladungssignals, gemäß Anspruch 1, **dadurch gekennzeichnet, dass** die Variablen so initialisiert werden, dass:

$$\hat{\mu}[1] = 0,$$

$$\hat{\sigma}^2[1] = 0,$$

$$\hat{\mu}_2[1] = 0,$$

$$\hat{\sigma}_2^2[1] = 0,$$

$$\hat{\mu}_3[1] = 0,$$

$$\hat{\mu}_{krit}[1] = 0.$$

3. Methode zur Erfassung eines Teilentladungssignals, gemäß einem der Ansprüche 1 und 2, **dadurch gekennzeichnet, dass** im Falle des Vorhandenseins einer Teilentladung der Beginn der Teilentladung weiterhin so bestimmt wird, dass zunächst der Wert der Varianz $\hat{\sigma}_2^2$ so bestimmt wird, dass:

$$\hat{\mu}_2[k] = \lambda_2 \cdot \hat{\mu}_2[k - 1] + (1 - \lambda_2) \cdot pd[k],$$

$$\hat{\sigma}_2^2[k] = \lambda_2 \cdot \hat{\sigma}_2^2[k - 1] + (1 - \lambda_2) \cdot (pd[k] - \hat{\mu}_2[k])^2,$$

wobei:

$\hat{\mu}_2[k]$ ist eine Schätzung des Mittelwertes des Signals zum Zeitpunkt k,

$\lambda_2$ ist der Vergesslichkeitsfaktor,

$\hat{\sigma}_2^2[k]$ ist eine Schätzung der Varianz (Zerstreuung) des gemessenen Signals zum Zeitpunkt k,

$\hat{\mu}_2[k - 1]$ ist eine Schätzung des Mittelwertes des Signals zum Zeitpunkt k-1,

$\hat{\sigma}_2^2[k$ ist eine Schätzung der Varianz des gemessenen Signals zum Zeitpunkt k-1, und

$pd[k]$ ist der Wert des gemessenen Signals zum Zeitpunkt k,

und weiterhin wird der Anteil des Varianzwertes $\hat{\sigma}_2^2$ zum Zeitpunkt k und zum Zeitpunkt k-Nvar so bestimmt, dass:

$$\Delta\hat{\sigma}_2^2[k] = \frac{\hat{\sigma}_2^2[k]}{\hat{\sigma}_2^2[k - Nvar]}$$

wobei Nvar ein wahlbarer Parameter ist, der die Anzahl der Varianzproben angibt, um die der Nenner des oben angeführten Bruchs gegenüber dem Zähler verschoben wird, und weiterhin der Zeitpunkt des Maximums k_max in einem Horizont, der kürzer als lag_max ab dem aktuellen Zeitpunkt k ist, gespeichert wird, wobei der Beginn der Entladung id_beg wie folgt bestimmt wird:

$$id\_beg = t\,k\_max - Nvar,$$

wobei, wenn in den folgenden dead_max-Proben kein neues Maximum bestimmt wird, wird der Zeitpunkt id_beg als Beginn der Entladung betrachtet, und wenn in den folgenden dead_max-Proben ein neues Maximum der Funktion $\Delta\hat{\sigma}_2^2$ gefunden wird, dann wird dieser neue Zeitpunkt id_beg als Beginn der Entladung betrachtet, und im Speicher wird die Angabe über den Beginn der Entladung id_beg aktualisiert.

4. Methode zur Erfassung eines Teilentladungssignals, gemäß Anspruch 2, **dadurch gekennzeichnet, dass** die Suche nach dem Beginn der Entladung nach Ablauf der **dead_max**-Proben ab dem Zeitpunkt der Entladungserfassung beendet wird.

5. Methode zur Erfassung eines Teilentladungssignals, gemäß einem der Ansprüche 1 bis 3, **dadurch gekennzeichnet, dass** im Falle des Vorhandenseins einer Teilentladung das Ende id_end der Teilentladung weiterhin so bestimmt wird, dass der Zeitpunkt, zu dem der Wert der Zielfunktion unter das 1,1-fache des Wertes der Zielfunktion zu Beginn der Teilentladung fällt, als Ende der Teilentladung erklärt wird, so dass:

$$\hat{\mu}_3[k] = \lambda_3 \cdot \hat{\mu}_3[k-1] + (1 - \lambda_3) \cdot pd[k],$$

$$\hat{\mu}_{krit}[k] = \lambda_3 \cdot \hat{\mu}_{krit}[k-1] + (1 - \lambda_3) \cdot |pd[k] - \hat{\mu}_3[k]|,$$

$$\hat{\mu}_{krit}[id\_end] < 1,1 \cdot \hat{\mu}_{krit}[id\_beg],$$

wobei:

$\hat{\mu}_3[k]$ ist eine Schätzung des Mittelwertes des Signals zum Zeitpunkt k,
$\lambda_3$ ist der Vergesslichkeitsfaktor,
$\hat{\mu}_3[k-1]$ ist eine Schätzung des Mittelwertes des Signals zum Zeitpunkt k-1,
$pd[k]$ ist der Wert des gemessenen Signals zum Zeitpunkt k,
$\hat{\mu}_{krit}[k]$ ist eine Schätzung des Mittelwertes des Absolutwertes des gemessenen Signals ohne die gleichgerichtete Komponente zum Zeitpunkt k, und
$\hat{\mu}_{krit}[k-1]$ ist eine Schätzung des Mittelwertes des Absolutwertes des gemessenen Signals ohne die gleichgerichtete Komponente zum Zeitpunkt k-1.

6. Methode zur Erfassung eines Teilentladungssignal, gemäß einem der Ansprüche 1 bis 4, **dadurch gekennzeichnet, dass** im Falle des Vorhandenseins einer Teilentladung die Gesamtladung *Q* weiterhin so bestimmt wird, dass:

$$Q = a \cdot \frac{1}{f_s} \sum_{i=id\_beg}^{id\_end} |pd[i]|$$

wobei:

*Q* ist die festgelegte Gesamtladung,
*a* ist der Kalibrierungskoeffizient für die Umwandlung (Umrechnung) der Signalfläche in Ladung,
$f_s$ ist die Abtastfrequenz, und
*i* ist der Summenberechnungsindex ab der Probe id_beg bis zur Probe id_end.

7. Methode zur Erfassung eines Teilentladungssignals, gemäß einem der Ansprüche 1 bis 5, **dadurch gekennzeichnet, dass** im Falle des Vorhandenseins einer Teilentladung weiterhin die Phase in der grundlegenden harmonischen Sinuskurve der Spannung im elektrischen Netzwerk so bestimmt wird, dass:

$$\varphi = \left(id_{beg}/f_s - t_0\right)\frac{360}{T},$$

Wobei:

$\varphi$ ist die Anfangsphase der Spannung im Netz zum Zeitpunkt der Teilentladung,
$t_0$ ist die absolute Zeit des Beginns der aktuellen Spannungsperiode,
*id_beg* ist der identifizierte Beginn der Entladung,
$f_s$ ist die Abtastfrequenz (Hz), und
*T* ist die Dauer der letzten vollständigen Periode.

wobei die Dauer *T* der letzten vollständigen Periode als Wechselspannungsperiode verwendet wird und $t_0$ die Zeit des Beginns der aktuellen Spannungsperiode ist.

**Revendications**

1.  Procédé de détection d'un signal de décharge partielle, notamment procédé de détection d'un signal de décharge partielle à partir d'un signal mesuré par un dispositif de mesure en au moins un point d'un réseau électrique, selon lequel sont d'abord effectuées l'initialisation des variables dans le dispositif de détection et le chargement des paramètres $N_{var}$, lag_max, dead_max, puis au moins une fois, le signal analogique large bande mesuré est acquis, lequel est converti en signal numérique dans un dispositif de numérisation, **caractérisé en ce que** le signal numérique est ensuite filtré en bande de manière à éliminer les composantes non liées à la manifestation de la décharge partielle, dont la fréquence est identifiée comme la plage de fréquences dans laquelle il ne se produit pas d'excitation transitoire large bande typique des amplitudes due aux décharges partielles, et ensuite, la variance du signal filtré est calculée à partir du signal filtré, laquelle contient au moins une constante de temps de filtrage de telle sorte que :

    $$\hat{\mu}[k] = \lambda \cdot \hat{\mu}[k-1] + (1-\lambda) \cdot pd_{filt}[k],$$

    $$\hat{\sigma}^2[k] = \lambda \cdot \hat{\sigma}^2[k-1] + (1-\lambda) \cdot \left(pd_{filt}[k] - \hat{\mu}[k]\right)^2,$$

    où :

    $\lambda$ est un facteur d'oubli compris entre 0 et 1, si la variance du signal filtré dépasse un seuil déterminé, alors la présence d'une décharge partielle est détectée à l'instant k,
    $\hat{\mu}[k]$ est l'estimation de la valeur moyenne du signal filtré à l'instant k, $\hat{\mu}[k-1]$ est l'estimation de la valeur moyenne à l'instant k-1,
    $pd_{filt}[k]$ est la valeur du signal filtré à l'instant k,
    $\hat{\sigma}^2[k]$ est l'estimation de la variance du signal filtré à l'instant k, et
    $\hat{\sigma}^2[k-1]$ est l'estimation de la variance à l'instant k-1.

2.  Procédé de détection d'un signal de décharge partielle selon la revendication 1, **caractérisé en ce que** les variables sont initialisées de la manière suivante:

    $$\hat{\mu}[1] = 0,$$

    $$\hat{\sigma}^2[1] = 0,$$

    $$\hat{\mu}_2[1] = 0,$$

    $$\hat{\sigma}_2^2[1] = 0,$$

$$\hat{\mu}_3[1] = 0,$$

$$\hat{\mu}_{krit}[1] = 0.$$

**3.** Procédé de détection d'un signal de décharge partielle selon l'une quelconque des revendications 1 et 2, **caractérisé en ce que,** en cas de présence d'une décharge partielle, le début de la décharge partielle est en outre déterminé de telle sorte que la valeur de la variance est d'abord déterminée $\hat{\sigma}_2^2$ comme suit :

$$\hat{\mu}_2[k] = \lambda_2 \cdot \hat{\mu}_2[k-1] + (1 - \lambda_2) \cdot pd[k],$$

$$\hat{\sigma}_2^2[k] = \lambda_2 \cdot \hat{\sigma}_2^2[k-1] + (1 - \lambda_2) \cdot (pd[k] - \hat{\mu}_2[k])^2,$$

où :

$\hat{\mu}_2[k]$ est l'estimation de la moyenne du signal à l'instant k,

$\lambda_2$ est le facteur d'oubli, $\hat{\sigma}_2^2[k]$ est l'estimation de la variance du signal mesuré à l'instant k,

$\hat{\mu}_2[k-1]$ est l'estimation de la valeur moyenne du signal à l'instant k-1,

$\hat{\sigma}_2^2[k-1]$ est l'estimation de la variance du signal mesuré à l'instant k-1, et

$pd[k]$ est la valeur du signal mesuré à l'instant k,

et le rapport entre la variance $\hat{\sigma}_2^2$ au temps k et celle au temps k-Nvar est ensuite déterminé comme suit :

$$\Delta\hat{\sigma}_2^2[k] = \frac{\hat{\sigma}_2^2[k]}{\hat{\sigma}_2^2[k - Nvar]}$$

où Nvar est un paramètre optionnel définissant le nombre d'échantillons de variance par lequel le dénominateur du rapport ci-dessus est décalé par rapport au numérateur ; et de plus, le moment du maximum k_max est mémorisé dans un horizon inférieur à lag_max par rapport au temps actuel k, tandis que le début de la décharge id_beg est défini comme suit:

$$id\_beg = k\_max - Nvar,$$

et dans le cas où aucun nouveau maximum n'est détecté dans les dead_max échantillons suivants, le moment id_beg est considéré comme le début de la décharge, tandis que si un nouveau maximum de la fonction est détecté dans les dead_max échantillons suivants, $\Delta\hat{\sigma}_2^2$ , ce nouveau moment est considéré comme le début de la décharge, et la mémoire est mise à jour avec cette nouvelle valeur de id_beg.

**4.** Procédé de détection d'un signal de décharge partielle selon la revendication 2, **caractérisé en ce que,** après l'écoulement de **dead_max** échantillons à partir du moment de détection de la décharge, la recherche du début de la décharge est terminée.

**5.** Procédé de détection d'un signal de décharge partielle selon l'une quelconque des revendications 1 à 3, **caractérisé en ce que,** en cas de présence d'une décharge partielle, la fin de la décharge partielle id end est en outre déterminée de telle sorte que le moment où la valeur de la fonction critère descend en dessous de 1,1 fois la valeur de cette fonction au début de la décharge partielle est déclaré comme étant la fin de la décharge partielle, selon :

$$\hat{\mu}_3[k] = \lambda_3 \cdot \hat{\mu}_3[k-1] + (1 - \lambda_3) \cdot pd[k],$$

$$\hat{\mu}_{krit}[k] = \lambda_3 \cdot \hat{\mu}_{krit}[k-1] + (1 - \lambda_3) \cdot |pd[k] - \hat{\mu}_3[k]|,$$

$$\hat{\mu}_{krit}[id\_end] < 1{,}1 \cdot \hat{\mu}_{krit}[id\_beg],$$

où :

$\hat{\mu}_3[k]$ est l'estimation de la moyenne du signal à l'instant k,

$\lambda_3$ est le facteur d'oubli,

$\hat{\mu}_3[k - 1]$ est l'estimation de la valeur moyenne du signal à l'instant k-1,

$pd[k]$ est la valeur du signal mesuré à l'instant k,

$\hat{\mu}_{krit}[k]$ est l'estimation de la valeur moyenne de la valeur absolue du signal mesuré sans composante continue à l'instant k, et

$\hat{\mu}_{krit}[k - 1]$ est l'estimation de la moyenne de la valeur absolue du signal sans composante continue à l'instant k-1,

6. Procédé de détection d'un signal de décharge partielle selon l'une quelconque des revendications 1 à 4, **caractérisé en ce que,** en cas de présence d'une décharge partielle, la charge totale est en outre déterminée $Q$ comme suit :

$$Q = a \cdot \frac{1}{f_s} \sum_{i=id\_beg}^{id\_end} |pd[i]|$$

où :

$Q$ est la charge totale déterminée,

$a$ est le coefficient de calibration pour la conversion de la surface du signal en charge électrique,

$f_s$ est la fréquence d'échantillonnage,

$i$ est l'indice de sommation des échantillons du signal entre id_beg et id_end.

7. Procédé de détection d'un signal de décharge partielle selon l'une quelconque des revendications 1 à 5, **caractérisé en ce que,** en cas de présence d'une décharge partielle, la phase dans la sinusoïde harmonique fondamentale de la tension dans le réseau électrique est en outre déterminée comme suit :

$$\varphi = \left(id_{beg}/f_s - t_0\right)\frac{360}{T},$$

où :

$\varphi$ est la phase initiale de la tension au moment de l'apparition de la décharge partielle,

$t_0$ est le temps absolu du début de la période actuelle de la tension,

$id\_beg$ est le début identifié de la décharge,

$f_s$ est la fréquence d'échantillonnage, et

T est la durée de la dernière période entière,

la durée de cette dernière période complète étant utilisée comme $T$ période de la tension alternative et correspondant $t_0$ au temps de début de la période de tension en cours.

Fig.1

Fig.2

Fig.3

Fig.4

Fig.5

24

Fig.6

EP 4 413 384 B1

Fig.7

EP 4 413 384 B1

Fig.8

Fig.9

Fig.10

EP 4 413 384 B1

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9390067 B
- US 6809523 B
- US 20170336459 A
- US 8126664 B
- US 2016003883 A1
- FR 2996312